# EUROPEAN PATENT APPLICATION

(11) **EP 0 531 237 A2**
(43) Date of publication of application: **10.03.1993**
(21) Application number: 92420288.0
(22) Date of filing: 31.08.1992
(51) Int. Cl.: H01L 39/24

(54) **Increased grain size superconductive thin films and process for their preparation**

(30) Priority: 06.09.1991 US 755977
(71) Applicant: EASTMAN KODAK COMPANY, Rochester, New York 14650-2201 (US)
(72) Inventor: Hung, Liang-sun, c/o Eastman Kodak Company, Rochester, New York 14650-2201 (US); Agostinelli, John Alfonse, c/o Eastman Kodak Comp., Rochester, New York 14650-2201 (US); Paz-pujalt, Gustavo R., c/o Eastman Kodak Comp., Rochester, New York 14650-2201 (US)
(74) Representative: Parent, Yves

(57) **Abstract**

A superconductive article is disclosed containing a a particulate thin film of a superconductive crystalline oxide satisfying the formula:

P₂Sr₂CaₙCuₙ₊₁O_{6+2n-z}

where
P represents Bi_{1-z}Pb_{z};
n is zero, 1, or 2; and
z is 0 to 0.30.
The particles of the thin film have a thickness of less than 5 µm and a mean projected area viewed normal to the substrate surface in excess of 1000 µm². The thin film is formed by (a) applying to the substrate a coating of a solution comprised of a volatilizable film forming solvent and metal-ligand compounds of each of P, Sr, Ca and Cu containing at least one thermally volatilizable organic ligand, (b) removing the volatile components of the coating by heating and (c) forming the residual components of the coating into the superconductive crystalline oxide coating by firing. The mean projected areas of the particles are increased by incorporating fluoro-substituted organic compounds in the coating solution to provide a F:Sr atomic ratio of at least 3:1 and firing to a temperature of from 800 to 860°C in forming the superconductive crystalline oxide.

## Description

The invention relates to superconductive articles and processes for their preparation.

Agostinelli and others U.S. Patent 4,950,643 discloses the formation of superconductive thin films formed by crystalline bismuth strontium calcium copper oxide. The films are constructed by providing each metal component of the final oxide in the form of a metal-organic ligand compound, such as a metal carboxylate; spin coating a solution of the metal-ligand compounds in the desired stoichiometric ratio onto a substrate; heating to decompose the organic ligands; and then heating to a temperature in the range of from 800 to 950°C to crystallize the coating.

High transition temperature (>100°K) superconductive crystalline bismuth strontium calcium oxide superconductive can be routinely prepared by the process of Agostinelli and others. However, maximum supportable critical current densities (the maximum current density that permits superconductive current transmission) have not been as high as those reportedly achieved using other approaches for forming thin films.

In one aspect this invention is directed to a superconductive article comprised of a substrate having a surface capable of supporting the formation of a superconductive bismuth strontium calcium oxide thin film and a particulate thin film of a superconductive crystalline oxide satisfying the formula:

P₂Sr₂CaₙCuₙ₊₁O_{6+2n-z}

where
P represents Bi_{1-z}Pb_{z};
n is zero, 1, or 2; and
z is 0 to 0.30.
The superconductive article is characterized in that the particles of the thin film have a thickness of less than 5 µm and a mean projected area viewed normal to the substrate surface in excess of 1000 µm².

The articles of the invention offer the advantage of reduced disruptions in the crystal structure of the thin film and increased current carrying capacity.

In another aspect this invention is directed to a process of forming a superconductive article comprised of a substrate having a surface capable of supporting the formation of a superconductive bismuth strontium calcium oxide thin film and a particulate thin film of a superconductive crystalline oxide satisfying the formula:

P₂Sr₂CaₙCuₙ₊₁O_{6+2n-z}

where
P represents Bi_{1-z}Pb_{z};
n is zero, 1, or 2; and
z is 0 to 0.30.
The superconductive crystalline oxide is formed by the steps of (a) applying to the substrate a coating of a solution comprised of a volatilizable film forming solvent and metal-ligand compounds of each of P, Sr, Ca and Cu containing at least one thermally volatilizable organic ligand, (b) removing the volatile components of the coating by heating and (c) forming the residual components of the coating into the superconductive crystalline oxide coating by firing.

The process is characterized in that the particles of the thin film are formed with a thickness of less than 5 µm and a mean projected area viewed normal to the substrate surface in excess of 1000 µm² by (a′) incorporating fluoro-substituted organic compounds in the coating solution to provide a F:Sr atomic ratio of at least 3:1 and (c′) firing to a temperature of from 800 to 860°C in forming the superconductive crystalline oxide.

The process of the invention offers the advantages of producing superconductive articles of a more uniform crystal structure. The articles are capable of supporting higher superconducting current densities than have heretofore been realized using comparable preparation procedures. Additionally, better quality superconductive films are more readily realized at lower firing temperatures as compared to conventional processes that thermally decompose metalorganic ligand compounds.
Figure 1 is an isometric schematic view of a unit cell on a monocrystalline substrate surface;
Figures 2, 3 and 4 are isometric schematic views of 2223, 2212 and 2201 unit cell sub-units, respectively; and
Figures 5(a) and 5(b) are photomicrographs of thin films.

The present invention is directed toward improving the crystal order and hence the superconductive current carrying capacity of thin (< 5 µm) films containing crystalline oxides of bismuth alkaline earth and copper. The invention is applicable to a family of oxides that satisfy the general formula:

(I) P₂Sr₂CaₙCuₙ₊₁O_{6+2n-z}

where
P represents Bi_{1-z}Pb_{z};
n is zero, 1 or 2; and
z is 0 to 0.30.
Specifically preferred are the 2223 compositions of the general formula:

(II) P₂Sr₂Ca₂Cu₃O_{10-z}

where P and z are as defined in formula I, and the 2212 compositions of the general formula:

(III) P₂Sr₂Ca₁Cu₂O_{8-z}

where P is as defined in formula I and z is 0 to 0.20.

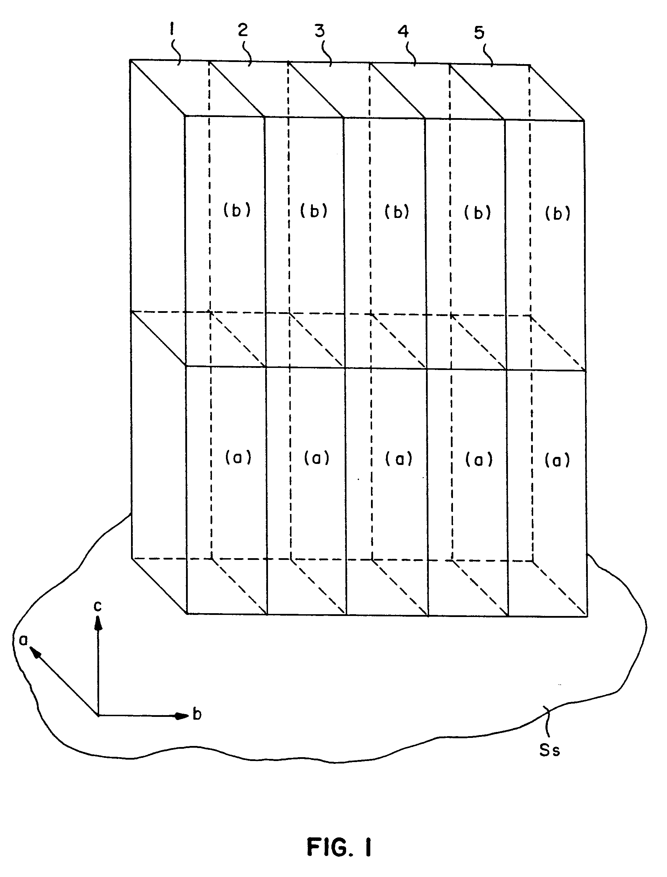

The oxides of formula I when properly crystallized are capable of producing superconductive thin films. A unit cell crystal structure compatible with superconductivity is shown in Figure 1 oriented on a substrate surface **Ss**. The longest dimension of the unit cell, its c-axis, is oriented normal to the substrate surface parallel to arrow **c**. The two remaining orthogonal (mutually perpendicular) axes of the unit cell are parallel to the substrate surface and parallel to the arrows **a** and **b**. Five unit cell sub-units **1**, **2**, **3**, **4** and **5** are shown on the substrate surface, each sub-unit including **(a)** and **(b)** portions relatively displaced along the c-axis. Because of minor sub-unit to sub-unit bond length perturbations in the direction of the b-axis, approximately 5 sub-units along the b-axis (the axis of intermediate length) are required to satisfy the formal crystallographic definition requirements of a unit cell. The unit cell a-axis (the axis of shortest length) is one sub-unit in length. Notice that the unit cell faces parallel to the c-axis (that is, the vertical unit cell faces as shown in Figure 1) are also each oriented parallel to one of the a and b-axes.

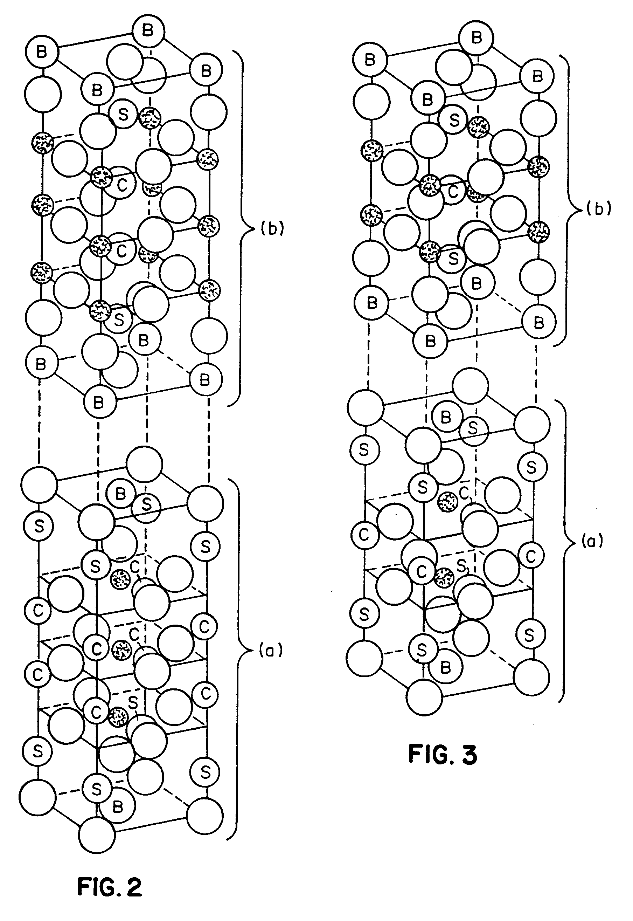

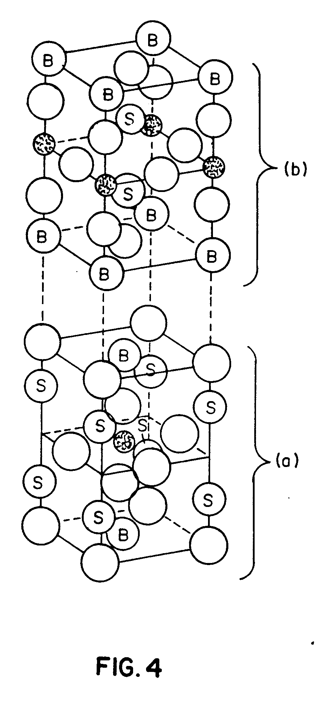

The oxides of formula I can form any one of three different superconductive crystal structures, depending upon the value of **n**. When **z** is zero (that is, when no lead is present) and **n** is 2, 1 or zero, the structures schematically shown in Figures 2, 3 or 4, respectively, result. In these figures the black spheres represent copper, the unlabeled spheres represent oxygen, and the spheres labeled **B,** **C** and **S** represent bismuth, calcium and strontium, respectively. For ease of visualization an entire atom is shown in each occurrence where any portion of the atom is included in a sub-unit. (Note that only of portion of each atom lying at an edge or face of a sub-unit is actually included within the sub-unit.) The central tier of atoms of each **(a)** sub-unit form the four corner tiers of each **(b)** sub-unit and vice versa. In an actual film the sole difference between an increment of layer thickness formed by **(a)** sub-units and an increment of layer thickness formed by **(b)** sub-units is a relative shift of one half sub-unit along each of the a and b-axes.

In a conventional superconductive thin film satisfying formula I the c-axes of the units cells of the crystalline oxide are oriented normal to the substrate surface, as shown in Figure 1. The minor axes (the a and b-axes) are parallel to the substrate surface, with the a and b-axes of each unit cell being orthogonally related.

Over the entire surface of the thin film there is, however, a wide array of different angular orientations of minor axes. The effect of the angular displacements of minor axes orientations from one area of the film to the next is to create a large number of individual microcrystalline film serpents (hereinafter also referred to as particles, grains or microcrystals) separated by high angle intergrain boundaries. Conventionally microcrystalline grains on average typically have a projected area viewed normal to the substrate surface of less than 100 µm². The areas of the individual grains correlate inversely with the number of high angle intergrain boundaries. Thus, the smaller the mean projected areas of the grains, the greater the number of high angle grain boundaries and the more internal disruptions to superconduction within the thin films and, as a consequence, conventional thin films suffer the disadvantage of exhibiting significantly limited superconductive current carrying capacity.

In the present invention a superconductive crystalline oxide thin film is formed on a substrate surface with a grain projected areas on average exceeding 1000 µm². This greatly reduces the number of high angle intergrain boundaries in the thin films and increases their superconductive current carrying capacity.

The present invention allows thin films, those of less than 5 µm (most commonly less than 2 µm in thickness and optimally less than 1 µm in thickness) to be realized with high average grain sizes, based on projected areas. This improvement in structure translates into thin films that exhibit both high superconductive current densities and high temperatures of superconductivity.

The individual grains of the thin films can have thicknesses that equal the total thickness of the thin films in which they are present. Thus, individual grains can exhibit any convenient thickness of less than 5 µm. However, the grains preferably have thicknesses of less than 1 µm. The ultimate minimum thickness of an individual grain is, of course, the length of the unit cell c-axis and, more typically, some small multiple of the until cell c-axis length. By limiting the thicknesses of the individual grains the thin films are formed of layers of grains, with grains in adjacent layers typically being at least partially laterally displaced, so that a typical grain in one layer overlaps a significant portion of the projected areas of two or more grains in a next adjacent layer. The partially overlapping faces of the grains in next adjacent layers provide current carrying interfaces that provide superconductive current conduction paths that electrically shunt the high angle grain boundaries of adjacent grains within a single layer. As the average projected areas of the grains is increased the areas of overlap between grains in adjacent layers are increased and the superconducting current capacity of the thin film as a whole is increased.

Superconducting onset (Tₒ) temperatures in excess of the temperature of liquid nitrogen (77°K) can be realized with the compositions of formula I, and superconducting transition temperatures (T_{c}) of greater than 100°K are contemplated. Maximum superconducting temperatures are realized when n in formula I is 2, with progressively lower temperatures being realizable when n is 1 or zero. When n is zero both Tₒ and T_{c} are well below the 77°K and 100°K values noted above.

Obtaining thin film superconductors with increased mean grain projected areas as described above has been made possible by an improvement in the so-called "MOD" process of thin film formation, described, for example, in Agostinelli and others U.S. Patent 4,950,643, the disclosure of which is here incorporated by reference.

In the MOD process the metals to be incorporated in the film (that is, the metals of formulae I, II or III) are each employed as starting materials in the form of metal-ligand compounds, where each metal-ligand compound includes at least one thermally volatilizable organic ligand. The organic ligands are selected for their film forming capabilities. In general the film forming capabilities of the organic ligands increase as a function of the number of carbon atoms they contain and as a function of chain branching, cyclic hydrocarbons and branched hydrocarbon chains being capable of producing superior films with fewer carbon atoms than linear hydrocarbon chains. Typically organic ligands are selected that contain up to about 30 carbon atoms. Individual metal ligands can have as few as 2 carbon atoms (that is, individual metal acetates are feasible), but preferably contain from 6 to 20 carbon atoms. To improve the film forming properties of the composition hydrocarbons or substituted hydrocarbons, preferably branched chain hydrocarbons or substituted hydrocarbons such as terpenes, of from 10 to 30 carbon atoms can be incorporated to assist in film formation.

In addition to selection on the basis of film forming properties the metal-ligand compounds are selected on their ability to thermally decompose rather than vaporize. Metal-organic ligand compounds (including metallo-organic and organo-metallic compounds), such as metal alkyls, alkoxides, β-diketone derivatives and metal salts of organic acids--for example, carboxylic acids, constitute preferred metal-ligand compounds. Copper is preferably employed as a metal carboxylate to minimize copper loss by vaporization.

Exemplary preferred organic ligands for the metal organic compounds include metal butyrates, 2-ethylhexanoates, naphthenates, neodecanoates, butoxides, isopropoxides, rosinates (for example, abietates), cyclohexanebutyrates and acetylacetonates. Exemplary film-forming agents include 2-ethylhexanoic acid, rosin (for example, abietic acid), ethyl lactate, 2-ethyoxyethyl acetate and pinene.

Any convenient thermally decomposable or volatilizable solvent for the metal-ligand compounds and the film-forming agents can be employed. Exemplary preferred film forming solvents include toluene, 2-ethylhexanoic acid, n-butyl acetate, ethyl lactate, propanol, pinene and mineral spirits.

It has been discovered quite unexpectedly that the incorporation of fluoro-substituted-organic compounds (herein employed to mean compounds containing one or more fluorine to carbon bonds) in the metalorganic coatings allows dramatically increased mean grain projected areas to be obtained. The result is even more surprising, since no evidence has been found that the fluorine remains in the crystalline oxide thin film after it emerges from firing.

It has been established that the effectiveness of fluoro-substituted organic compounds to increase mean grain projected areas results from having present in metal-ligand coating a critical ratio of strontium to fluorine atoms. At least a 3:1 F:Sr atomic ratio is required to increase the mean grain projected areas above 1000 µm², with at least a 4:1 F:Sr atomic ratio being preferred. While in general no further advantage can be realized by increasing the F:Sr atomic ratio above 8:1, it is possible to increase the F:Sr atomic ratio to 100:1 or more without adverse effect. F:Sr atomic ratios of from 4:1 to 50:1 are generally preferred, with atomic ratios of from 8:1 to 20:1 being optimum.

The requisite fluorine content can be incorporated in the metal-organic ligand coatings by introducing any convenient organic compound having one or more fluorine to carbon bonds. While fluoro-substituted organic compounds can be selected solely for their utility in supplying the required fluorine atoms, it is preferred to select fluoro-substituted organic compounds satisfying the film forming characteristics discussed above to insure intimate dispersion of the fluorine atoms in the coatings. In a specifically preferred form of the invention the ligands of the metal-organic compounds and/or the film-forming agents are fluoro-substituted, thereby obviating the necessity of including yet anther ingredient in forming the coating. It is specifically contemplated to blend a metal-organic compound lacking fluorine substitution with a similar fluoro-substituted metal organic compound to achieve the exact proportion of fluorine to strontium desired. The highest levels of precision in establishing fluorine to strontium ratios is realized by including fluoro-substituents in the strontium-organic ligand compound. This establishes the F:Sr ratio independently of any variances in blending other components.

Once a coating composition has been formulated containing the metals of formulae I, II or III in their indicated ratios and the desired F:Sr ratio, the coating composition is applied to the support surface by any convenient coating technique. Spin casting is a particularly preferred technique, since it allows control of both the thickness and uniformity of the spin cast layer. Spin casting is well suited for laying down layers of up to about 1.5 µm in thickness, but spin cast layers are typically less than 1.0 µm in thickness.

Following coating of the metal-organic compounds the coated substrate is heated to a temperature sufficient to volatilize or decompose thermally the organic components of the coating. While removal temperatures vary as a function of the organic components selected, no organic residue remains at a temperature of 600°C. Although this temperature is well in excess of that required to remove organic residues from the coating, it is still well below the temperatures required for crystalline oxide formation.

Because of solvent removal as well as thermal decomposition of organic ligands the coating after heating is much thinner than that originally coated. If a thicker crystalline oxide coating is desired than can be generated using a single spin casting step, it is recognized that the spin casting step and the heating step can be repeated, once or several times, in sequence to achieve the desired crystalline oxide film thickness. Successive coating and heating steps also offer the advantage of better protecting the coating from substrate contaminants, if present.

Conversion of the coating after removal of organic residues to a crystalline oxide with unit cell axial alignment can be achieved at temperatures in the range of from 800 to 860°C. Crystallization temperatures are a function of both the lead content of the coating and the crystalline form being formed. The 2101, 2212 and 2223 crystalline forms require progressively high temperatures for their formation. For the 2101 crystalline form preferred firing temperatures are in the range of from 800 to 840°C. For the 2212 crystalline form preferred firing temperatures are in the range of from 800 to 850°C, which is below the 850 to 920°C preferred range for the 2212 crystalline form taught by Agostinelli and others. For the 2223 crystalline form preferred firing temperatures are in the range of from 800 to 860°C, which is well below the approximately 890°C firing temperature typically employed to produce this crystalline form.

If desired, the steps of coating, heating and firing described above can be repeated in sequence two or more times to produce a thin film having increased mean grain projected areas.

Apart from the features specifically discussed above fabrication of the crystalline oxides with unit cell aligned crystal axes can take any convenient conventional form. The thin films can, for example, be formed as taught by Agostinelli and others, cited above and here incorporated by reference, except as otherwise noted.

An advantage of the present invention is that it is applicable to forming thin film superconductive articles employing any substrate known in the art to be useful in preparing superconductive crystalline thin film bismuth strontium copper oxides optionally containing lead and/or calcium. For example, any substrate surface taught to be useful by Agostinelli and others, cited above and here incorporated by reference, can be employed.

It is preferred, but not required, that the substrate surface be chosen to support the epitaxial deposition of the thin film crystalline oxide. Substrate surfaces that exhibit a perovskite crystal structure are particularly compatible with supporting formation of the oriented crystalline oxide thin film. Exemplary of preferred perovskites for forming the substrate surface are strontium titanate, lanthanum aluminate, lanthanum gallium oxide and potassium tantalate. In addition to the perovskites, monocrystalline magnesium oxide (magnesia), hafnium oxide (hafnia) and zirconium oxide (zirconia) are also useful materials for forming the substrate surface supporting the oriented crystalline oxide thin film. Hafnium and zirconium have almost identical chemical and physical properties and can be used interchangeably or mixed in any proportions. As between hafnia and zirconia the latter is less expensive and therefore much more extensively employed in the art. Yttria stabilized zirconia, where yttrium displaces from 5 to 15 percent of the zirconium on an atomic basis, is a monocrystalline substrate that has been widely used in fabricating superconductive films. Although other crystal face orientations are possible, the crystal surface presented by the substrate is preferably a {100} surface.

These monocrystalline substrate surfaces can be provided by a unitary element formed throughout by a single monocrystalline material. Alternatively, the substrate can contain a monocrystalline support structure onto which one or more layers are epitaxially grown to form the required monocrystalline substrate surface. For example, on monocrystalline silicon wafers monocrystalline layers of monocrystalline layers of strontium titanate have been epitaxially grown, as disclosed by H. Ishiwara and K. Azuma, "Oriented Growth of SrTiO₃ Films on Si(100) Substrates Using In-Situ Cleaning by Excited Hydrogen", *Mat. Res. Soc. Symp. Proc.,* Vol. 116, 1988 Materials Research Society, pp. 369-375, and monocrystalline layers of magnesia have been epitaxially grown, as disclosed by D.K. Fork, F.A. Ponce, J.C. Tramontana and T.H. Geballe, "Epitaxial MgO on Si(001) for Y-Ba-Cu-O Thin-Film Growth by Pulsed Laser Deposition", *Appl. Phys. Letter,***58**(20), 20 May 1991, pp. 2294-2296. Monocrystalline layers of yttria stabilized zirconia have been grown on sapphire (monocrystalline alumina), as disclosed by H. Schmidt, K. Hradil, W. Hösler, W. Wersing, G. Gieres and R.J. Seeböck, "Eipitaxial YBa₂Cu₃Oₓ Thin Films on Sapphire Using a Y-Stabilized ZrO₂ Buffer Layer", *Appl. Phys. Letter,***59**(2), 8 July 1991, pp. 222-224. Still other useful monocrystalline substrate materials are disclosed by Takemura U.S. Patent 5,032,571.

In addition to monocrystalline substrate surfaces the invention is also applicable to substrate surfaces that are polycrystalline. For example, polycrystalline magnesium oxide or polycrystalline forms of the various perovskite materials noted above as well as polycrystalline substrate surfaces of zirconia and hafnia are all contemplated. Hung and Chatterjee U.S. Serial Nos. 475,527 and 475,528, filed Feb. 6, 1990, commonly assigned, disclose the deposition of crystalline bismuth strontium calcium copper oxides on a support comprised of an austenitic alloy of chromium and one or more group VIII period 4 metals (for example stainless steel) employing as a barrier layer hafnia or zirconia, respectively, where the zirconia barrier layer contains thermal stress relief fissures filled with another barrier material known to be compatible with the superconductive crystalline oxide (for example, hafnia, strontium titanate or magnesia). Mir and others U.S. Patent 4,988,674 discloses superconductive crystalline oxide coatings on metal barrier layers chosen from groups 8 to 11 inclusive and periods 5 and 6 of the Periodic Table of Elements (that is, the platinum group metals, silver and gold). Hung and Agostinelli U.S. Patents 4,908,348 and 4,994,434 disclose barrier layer systems for a silicon substrate including silicon dioxide (SiO₂), zirconium silicide (ZrSi) and zirconia (ZrO₂). Copper oxide is also a feasible substrate surface material, as illustrated by Agostinelli and Lubberts U.S. Patent 4,956,335.

### Examples

Except as otherwise indicated all weight percentages are based on total weight.

### Example 1 (Control)

A metal-organic ligand composition containing bismuth, strontium, calcium and copper in a 2:2:1:2 atomic ratio (hereinafter referred to as 2212 Precursor 1) was prepared by mixing a bismuth precursor composition containing bismuth 2-ethylhexanoate, a strontium precursor composition containing strontium cyclohexanebutyrate, a calcium precursor composition containing calcium 2-ethylhexanoate and a copper precursor composition containing copper 2-ethylhexanoate. The bismuth precursor, containing 18.73% by weight bismuth, and the calcium precursor, containing 4.10% by weight calcium, were prepared as described by Agostinelli and others U.S. Patent 4,950,643. The strontium precursor was strontium cyclohexane-butyrate purchased commercially with an assay indicating a strontium concentration of 19.4% by weight strontium. The copper precursor, with a copper concentration of 6.31% by weight, was prepared by mixing 2.0 g of copper acetate with 8.0 g of 2-ethylhexanoic acid. The individual precursors were mixed in a weight ratio of 1:0.438:0.405:0.903 and then heated to boiling until no solids remained. The 2212 Precursor 1 had a concentration of about 1.63 X 10⁻⁴ mole (based on the 2212 crystalline oxide to be formed) per gram. To enhance its film forming properties 7% by weight Kodak 2315™ (rosin) was added with gentle heating until all the rosin was dissolved.

2212 Precursor 1 was spin coated on a polycrystalline silver foil having a thickness of 0.025 mm at 4000 rpm for 20 seconds. The coated film was then heated on a hot plate to a thermal decomposition temperature of 450°C. The coating then fired in air at a temperature of 865°C for 10 minutes in air.

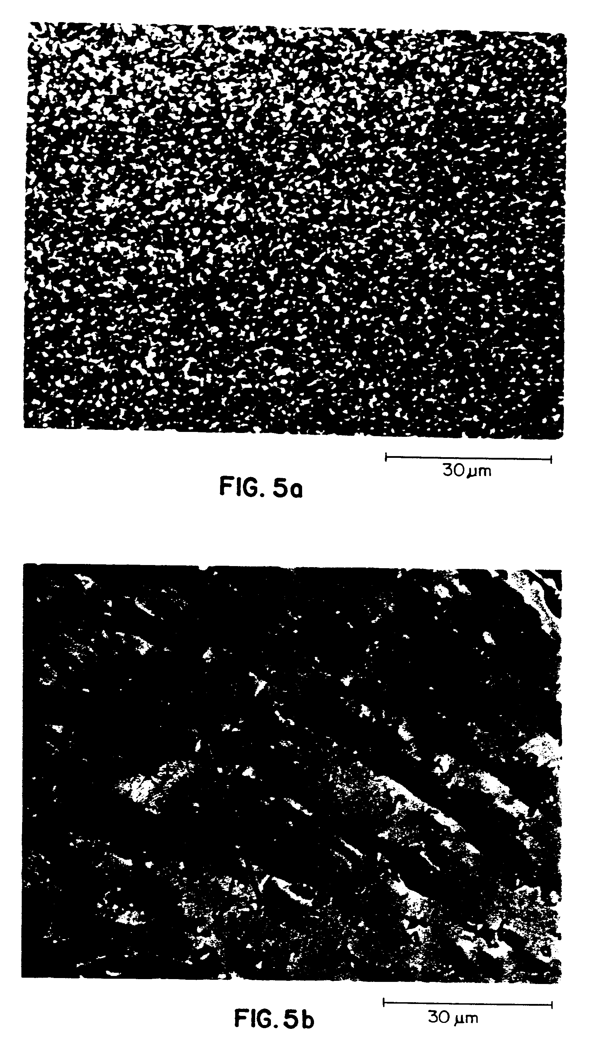

Microscopic examination revealed a polycrystalline coating on the substrate surface having a mean grain effective circular diameter (ECD) in the range of from 1 to 2 µm. A photomicrograph of the grains is shown in Figure 5(a).

### Example 2

The procedure of Example 1 was repeated, except that (a) the 2212 Precursor 1 was mixed with heptafluorobutyric acid at a ratio of 1:0.17 (F:Sr atomic ratio 8:1) and firing was conducted for 30 minutes at 820°C.

Microscopic examination revealed grains in the crystalline oxide thin that were typically 10 to 20 µm in width and several hundred µm in length (that is, well in excess of 1000 µm² in projected area). A photomicrograph of the grains of the crystalline oxide is shown in Figure 5(b).

## Claims

1. A superconductive article comprised of
a substrate having a surface capable of supporting the formation of a superconductive bismuth strontium calcium oxide thin film and
a particulate thin film of a superconductive crystalline oxide satisfying the formula:
P₂Sr₂CaₙCuₙ₊₁O_{6+2n-z}
where
P represents Bi_{1-z}Pb_{z};
n is zero, 1, or 2; and
z is 0 to 0.30;
CHARACTERIZED IN THAT the particles of the thin film have a thickness of less than 5 µm and a mean projected area viewed normal to the substrate surface in excess of 1000 µm².

2. An article according to claim 1 further characterized in that the particles of the thin film have a thickness of less than 1 µm.

3. An article according to claim 1 further characterized in that the substrate surface is polycrystalline.

4. An article according to claim 1 further characterized in that the superconductive crystalline oxide layer satisfies the formula:
P₂Sr₂Ca₁Cu₂O_{8-z}
where
P represents Bi_{1-z}Pb_{z} and
z is 0 to 0.20.

5. An article according to claim 1 further characterized in that the superconductive crystalline oxide layer satisfies the formula:
P₂Sr₂Ca₂Cu₃O_{10-z}
where
P represents Bi_{1-z}Pb_{z} and
z is 0 to 0.30.

6. A process of forming a superconductive article comprised of a substrate having a surface capable of supporting the formation of a superconductive bismuth strontium calcium oxide thin film and a particulate thin film of a superconductive crystalline oxide satisfying the formula:
P₂Sr₂CaₙCuₙ₊₁O_{6+2n-z}
where
P represents Bi_{1-z}Pb_{z};
n is zero, 1, or 2; and
z is 0 to 0.30;
the superconductive crystalline oxide being formed by the steps of
(a) applying to the substrate a coating of a solution comprised of a volatilizable film forming solvent and metal-ligand compounds of each of P, Sr, Ca and Cu containing at least one thermally volatilizable organic ligand,
(b) removing the volatile components of the coating by heating and
(c) forming the residual components of the coating into the superconductive crystalline oxide coating by firing,
CHARACTERIZED IN THAT the particles of the thin film are formed with a thickness of less than 5 µm and a mean projected area viewed normal to the substrate surface in excess of 1000 µm² by
(a′) incorporating fluoro-substituted organic compounds in the coating solution to provide a F:Sr atomic ratio of at least 3:1 and
(c′) firing to a temperature of from 800 to 860°C in forming the superconductive crystalline oxide.

7. A process according to claim 6 further characterized in that the F:Sr atomic ratio is in the range of from 4:1 to 50:1.

8. A process according to claim 7 further characterized in that the F:Sr atomic ratio is in the range of from 8:1 to 20:1.

9. A process according to claim 6 further characterized in that the superconductive crystalline oxide layer satisfies the formula:
P₂Sr₂Ca₁Cu₂0_{8-z}
where
P represents Bi_{1-z}Pb_{z} and
z is 0 to 0.20 and
firing is undertaken at a temperature of from 800 to 850°C.

10. A process according to claim 6 further characterized in that the superconductive crystalline oxide layer satisfies the formula:
P₂Sr₂Ca₂Cu₃O_{10-z}
where
P represents Bi_{1-z}Pb_{z} and
z is 0 to 0.30.
